# EUROPÄISCHE PATENTSCHRIFT

(11) **EP 3 076 488 B1**
(45) Veröffentlichungstag und Bekanntmachung des Hinweises auf die Patenterteilung: **20.11.2019**
(21) Anmeldenummer: 16156603.9
(22) Anmeldetag: 19.02.2016
(51) Int. Cl.: H01R 12/52, H01R 12/62, H05K 1/14, H05K 1/11, H05K 3/20

(54) **ELEKTRISCHER VERBINDER**
ELECTRICAL CONNECTOR
CONNECTEUR ÉLECTRIQUE

(30) Priorität: 31.03.2015 DE 102015104923
(43) Veröffentlichungstag der Anmeldung: 05.10.2016
(73) Patentinhaber: SUMIDA flexible connections GmbH, 01454 Radeberg (DE)
(72) Erfinder: HEINE, Patrick, 01917 Kamenz OT Wiesa (DE)
(74) Vertreter: Riechelmann & Carlsohn Patentanwälte PartG mbB

(56) Entgegenhaltungen:
- EP-A2- 0 903 969
- WO-A1-93/24939
- US-A- 3 168 617
- US-A- 3 601 755

## Beschreibung

Die Erfindung betrifft einen elektrischen Verbinder, der insbesondere zum elektrischen Verbinden von Leiterplatten sowie elektrischen und elektronischen Bauelementen geeignet ist.

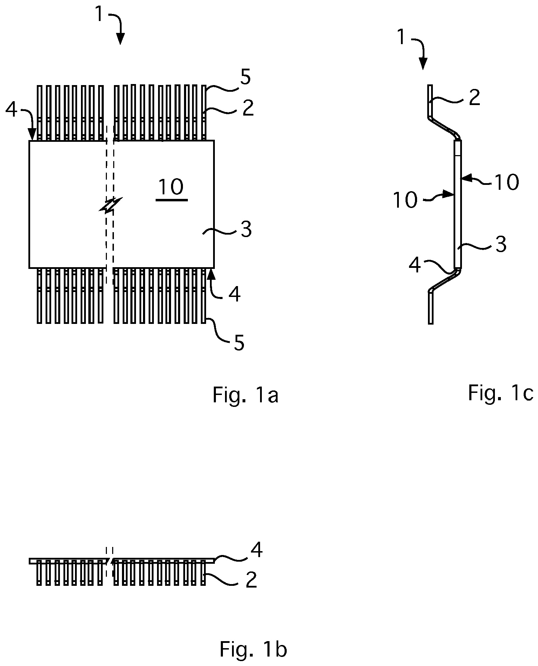

Zum Verbinden zweier Leiterplatten sind elektrische Verbinder erforderlich, die den Stromfluss zwischen den Leiterbahnen der einen Leiterplatte und den Leiterbahnen der anderen Leiterplatte ermöglichen können. Ein derartiger elektrischer Verbinder ist aus der DE 10 2005 056 147 A1 der Sumida flexible connections GmbH bekannt, der auch als SMD-Verbinder (SMD: surface-mounted device) für die Oberflächenmontage (engl.: surface-mounted technology, SMT) eingesetzt werden kann. Gemäß der dortigen Figur 1 umfasst der elektrische Verbinder ein Flachbandkabel, an dessen isolationsfreien Enden z-förmige Leiterenden ausgebildet sind. Der äußere Schenkel der z-förmigen Leiterenden wird in Kontakt mit der Leiterbahn einer Leiterplatte gebracht.

Elektrische Verbinder können hohen mechanischen Belastungen ausgesetzt sein. Das ist insbesondere dann der Fall, wenn sich die Anschlüsse der beiden elektrischen oder elektronischen Bauelemente, die mit dem elektrischen Verbinder verbunden werden sollen, nicht in einer Ebene befinden. Der elektrische Verbinder muss dann gebogen werden. Insbesondere auf engem Raum, der nur den Einsatz elektrischer Verbinder mit einer kurzen Isolationszone gestattet, sind die Leiter innerhalb der Isolationszone erheblichen Biegebeanspruchungen ausgesetzt. Zur Verbindung von elektrischen oder elektronischen Bauelementen sind herkömmliche elektrische Verbinder daher nur bedingt geeignet. Werden die Leiter innerhalb der Isolationszone zu stark oder zu häufig gebogen, so können die Leiter brechen oder anbrechen, was ihre elektrischen Eigenschaften erheblich beeinflussen kann.

Auf den ersten Blick könnte dieses Problem gelöst werden, indem elektrische Verbinder bereitgestellt werden, die speziell an die räumliche Anordnung der Bauelemente, zu deren Verbindung sie eingesetzt werden sollen, angepasst sind. Allerdings würde dies die Fertigung einer Vielzahl unterschiedlicher Varianten von elektrischen Verbindern erfordern. Eine Veränderung der räumlichen Anordnung der Bauelemente würde damit die Entwicklung und den Einsatz anderer elektrischer Verbinder erfordern. Vollständig ungelöst bliebe das Problem, wenn die verbundenen Bauelemente ihre räumliche Lage zueinander funktionsgemäß wiederholt ändern. Das ist beispielsweise dann der Fall, wenn eines der Bauelemente zu dem anderen Bauelement beweglich angeordnet ist. Denkbar wäre auch der Einsatz derart dünner Flachleiter, beispielsweise folienartiger Flachleiter, die einer Biegung kaum mechanischen Widerstand entgegensetzen. Allerdings weisen solche Folien weder die erforderlichen elektrischen Eigenschaften auf, noch sind die freiliegenden Bereiche solcher Folien für die SMD-Montage geeignet.

DE 38 42 572 A1 der Robert Bosch GmbH beschreibt ein Verfahren zur Herstellung eines elektrischen Verbinders, der zum elektrischen Verbinden der beiden Leiterplatten eines Hörgerätes eingesetzt werden soll. Der elektrische Verbinder erfordert keine Fixierungselemente. Das Verfahren umfasst die Herstellung eines sogenannten Lötkammes. Dazu wird zunächst ein Blechstreifen bereitgestellt, aus dem parallele Leiterstreifen durch Ätzen oder Stanzen herausgearbeitet worden sind. Die Leiterstreifen sind an ihren beiden Enden jeweils durch Querstege miteinander verbunden. In einem, bezogen auf die Längsrichtung der Leiterstreifen, mittleren Bereich wird auf den Lötkamm beidseitig ein Isoliermaterial zur Ausbildung der Isolationszone aufgebracht. Dabei liegen die Leiterstreifen an ihren Enden und die beiden Querstege frei. Nach dem Entfernen der Querstege kann der so erhaltene Lötkamm zur Verbindung der beiden Leiterplatten eingesetzt werden. Dazu liegen die Leiterplatten - und damit deren Anschlüsse (in DE 38 42 572 A1 als Kontaktflächen bezeichnet) - in einer Ebene (siehe dort Fig. 4). Nach dem Verbinden werden die beiden Leiterplatten parallel zueinander geklappt. Dabei müssen die Leiterstreifen jeweils an beiden freiliegenden Enden abgewinkelt, d. h. gebogen werden. Das ist mit einer hohen Beanspruchung der Leiterstreifen verbunden. Eine Biegung innerhalb der Isolationszone ist nicht vorgesehen.

Bei der Herstellung eines Lötkammes ist zu beachten, dass die Materialwahl für die verwendeten Blechstreifen Einfluss auf die zu verwendende Herstellungsmethode hat. Zum Stanzen ist ein relativ hartes Material erforderlich. Weiche Materialien können nicht gestanzt werden. Weiches Material ließe sich allerdings leichter biegen.

Aus WO 93/24939 A1 ist ein Kabel bekannt, das flexible Leiter aufweist, die aus einem steifen Kompositmaterial gebildet sind. US 3,601,755 B offenbart ein Kabel, dessen Leiter aus Runddrähten gebildet sind, wobei ein flacher Abschnitt zwischen zwei runden Abschnitten liegt. US 3,168,617 B offenbart ein Kabel, das Flachleiter aufweist, die über ihre gesamte Länge dieselbe Stärke haben. EP 0 903 969 A2 zeigt einen Folienverbinder, der einen Biegebereich aufweist, der zwischen Abständen A liegt, die wiederum an Anschlüsse C angrenzen. Die Abstände A dienen der Beabstandung des Biegebereiches von den Leiterplatten, die mittels des Leiterplattenverbinders verbunden werden sollen. Die Abstände A haben einen S-förmigen Verlauf. Der Biegebereich ist dünner ausgebildet.

Aufgabe der Erfindung ist es, die Nachteile nach dem Stand der Technik zu beseitigen. Es soll insbesondere ein elektrischer Verbinder angegeben werden, der hohen Biegebeanspruchungen standhält.

Diese Aufgabe wird durch die Merkmale des Anspruchs 1 gelöst. Zweckmäßige Ausgestaltungen der Erfindungen ergeben sich aus den Merkmalen der Unteransprüche.

Nach Maßgabe der Erfindung ist ein elektrischer Verbinder vorgesehen, der insbesondere zum Verbinden von Leiterplatten geeignet ist. Der Verbinder weist mehrere voneinander beabstandete Flachleiter auf, die in ein elektrisch isolierendes Material unter Ausbildung einer Isolationszone, in der die Flachleiter parallel zueinander verlaufen, eingebettet sind und an ihren Enden jeweils mit einem freiliegenden Abschnitt über die Querkanten der Isolationszone hinausragen. Jeder Flachleiter weist innerhalb der Isolationszone mehrere erste Abschnitte auf, wobei jeder erste Abschnitt zwischen zwei zweiten Abschnitten angeordnet ist, wobei der erste Abschnitt eine geringere Dicke als die zweiten Abschnitte aufweist. Die ersten und zweiten Abschnitte eines Flachleiters weisen die gleiche Breite auf.

Im Sinne der vorliegenden Erfindung liegt ein erster Abschnitt eines Flachleiters zwischen zwei zweiten Abschnitten des Flachleiters, wenn der erste Abschnitt mit einem Ende an ein Ende eines zweiten Abschnittes und mit seinem anderen Ende an ein Ende des anderen zweiten Abschnittes angrenzt. Der erste Abschnitt sollte an eine Querkante der Isolationszone angrenzen. Vielmehr können an beide Querkanten der Isolationszone zweite Abschnitte des Flachleiters angrenzen.

Die Flachleiter weisen innerhalb der Isolationszone mehrere erste Abschnitte auf. Da die ersten Abschnitte eine geringere Dicke als die zweiten Abschnitte haben, sind die Flachleiter an den ersten Abschnitten geschwächt. Diese Schwächung ermöglicht es, den elektrischen Verbinder leichter zu biegen. Der erfindungsgemäße elektrische Verbinder erlaubt eine Biegung der Flachleiter innerhalb der Isolationszone.

Jeder Flachleiter weist mehrere erste Abschnitte auf, bevorzugt drei erste Abschnitte oder mehr. Auf diese Weise verteilt sich die Belastung des Flachleiters durch das Biegen auf mehrere Bereiche, was ein Knicken der Flachleiter in einem der ersten Bereiche verhindert. Ein solches Knicken kann auftreten, wenn nur ein erster Abschnitt mit zu geringer Dicke vorgesehen ist. Es ist aus diesem Grund bevorzugt, dass die Dicke der ersten Abschnitte mindestens 25 % der Dicke eines zweiten Abschnittes beträgt. Ebenso ist es bevorzugt, dass die Dicke der ersten Abschnitte höchstens 95 % oder weniger der Dicke der zweiten Abschnitte beträgt. In einer bevorzugten Ausführungsform liegt die Dicke der ersten Abschnitt zwischen 30 und 70 % der Dicke der zweiten Abschnitte, stärker bevorzugt zwischen 45 und 55 % und besonders bevorzugt bei 50 %.

Der Ausdruck "Flachleiter" bezieht sich auf einen Leiter mit im Wesentlichen rechteckigem Querschnitt, wobei die Höhe des Leiters geringer als die Breite des Leiters in. Die Kanten des Leiters können abgerundet sein. Die Höhe der zweiten Abschnitte kann beispielsweise 0,2 mm oder weniger, bevorzugt 0,1 mm oder weniger betragen; die Breite der ersten und zweiten Abschnitte kann beispielsweise 0,5 bis 2 mm betragen.

Um das Biegen der Flachleiter innerhalb der Isolationszone zu erleichtern, ist einer der ersten Abschnitte mittig, bezogen auf die Längsrichtung des Flachleiters, innerhalb der Isolationszone ausgebildet. Es ist bevorzugt, dass, wenn die Anzahl der ersten Abschnitte einer ungeraden Zahl entspricht, der mittlere der ersten Abschnitte der, bezogen auf die Längsrichtung des Flachleiters, mittig ausgebildete erste Abschnitt ist.

Vorzugsweise sind die Schwächungen der Flachleiter durch die ersten Abschnitte nur auf einer Flächenseite der Flachleiter ausgebildet. In diesem Fall weisen die ersten und zweiten Abschnitte des Flachleiters eine gemeinsame erste Flächenseite auf, während die zweiten Flächenseiten des ersten Abschnittes versetzt zu der zweiten Flächenseite der zweiten Abschnitte ausgebildet sind. Eine solche Ausbildung der Schwächungen ist zweckmäßig, wenn die Flachleiter des elektrischen Verbinders nur in einer Richtung gebogen werden, und zwar in der Richtung, in der die Schwächungen ausgebildet sind. Unter einer gemeinsamen Flächenseite wird eine Flächenseite verstanden, in der kein Versatz zwischen den ersten und zweiten Abschnitten ausgebildet ist.

Alternativ kann vorgesehen sein, dass Schwächungen der Flachleiter durch die ersten Abschnitte auf beiden Flächenseiten der Flachleiter ausgebildet sind. In einer ersten Variante kann dabei vorgesehen sein, dass die ersten Flächenseiten der ersten Abschnitte versetzt zu den ersten Flächenseiten der zweiten Abschnitte und die zweiten Flächenseiten der ersten Abschnitte versetzt zu den zweiten Flächenseiten der zweiten Abschnitte angeordnet sind. In einer zweiten Variante kann vorgesehen sein, dass, wenn mehrere erste Abschnitte vorgesehen sind, alternierend auf einen ersten Abschnitt, dessen erste Flächenseite versetzt zu den ersten Flächenseiten der zweiten Abschnitte und dessen zweite Flächenseite nicht versetzt zu den zweiten Flächenseiten der zweite Abschnitte ausgebildet ist, ein erster Abschnitt folgt, dessen zweite Flächenseite versetzt zu den zweiten Flächenseiten der zweiten Abschnitte und dessen erste Flächenseite nicht versetzt zu den ersten Flächenseiten der zweiten Abschnitte ausgebildet ist.

Die Flachleiter haben innerhalb der Isolationszone die gleiche Breite, d. h. die ersten Abschnitte und die zweiten Abschnitte unterscheiden sich nur in ihrer Dicke, nicht aber in ihrer Breite. Sind mehrere erste Abschnitte vorgesehen, so können die ersten Abschnitte die gleiche Länge aufweisen. Alternativ können die ersten Abschnitte aber auch unterschiedliche Längen aufweisen. So kann der Flachleiter zumindest einen ersten Abschnitt einer ersten Länge und zumindest einen ersten Abschnitt einer zweiten Länge aufweisen, wobei die erste Länge länger als die zweite Länge ist. Beispielsweise kann vorgesehen sein, dass der mittig ausgebildete erste Abschnitt länger als die übrigen ersten Abschnitte ist. Die übrigen ersten Abschnitte können jeweils die gleiche Länge aufweisen.

Die Dicke der freiliegenden Abschnitte der Flachleiter sollte der Dicke der zweiten Abschnitte der Flachleiter innerhalb der Isolationszone entsprechen. Die freiliegenden Abschnitte bilden die Kontakte zum Kontaktieren der zu verbindenden elektrischen oder elektronischen Bauelemente. Die freiliegenden Abschnitte können verformt sein, beispielsweise abgewickelt, gekrümmt oder z-förmig ausgebildet sein.

Vorzugsweise besitzen alle Flachleiter zumindest innerhalb der Isolationszone den gleichen Aufbau. Dabei sollten die ersten und zweiten Abschnitte der Flachleiter fluchtend zueinander ausgebildet sein.

Es kann vorgesehen sein, dass an beide Querkanten der Isolationszone zweite Abschnitte des Flachleiters angrenzen. Alternativ kann vorgesehen sein, dass jeder Flachleiter innerhalb der Isolationszone einen ersten Bereich aufweist, der zwischen zwei zweiten Bereichen liegt, wobei
- im ersten Bereich erste und zweite Abschnitte ausgebildet sind,
- die ersten Abschnitte nur im ersten Bereich ausgebildet sind,
- die zweiten Bereiche an die Querkanten der Isolationszone angrenzen, und
- die Dicke der Flachleiter in den zweiten Bereichen der Dicke der zweiten Abschnitte der Flachleiter im ersten Bereich entspricht.

Vorzugsweise weisen der erste Bereich und die zweiten Bereiche jeweils die gleiche Länge auf.

Die Flachleiter des erfindungsgemäßen Verbinders können Kupferleiter, Aluminiumleiter oder Leiter aus einem anderen Material, das den elektrischen Strom leitet, sein. Bevorzugt sind die Flachleiter Kupferleiter. Die Flachleiter sollten aus einem lötbaren Material bestehen. Die Flachleiter können eine Oberflächenveredelung aufweisen, beispielsweise eine Beschichtung aus Silber, Gold, Zinn oder Palladium. Die Beschichtung kann auf dem gesamten Flachleiter ausgebildet sein oder nur auf den freiliegenden Abschnitten des Flachleiters.

Die Flachleiter verlaufen innerhalb der Isolationszone parallel zueinander. Die Leiter sind vorzugsweise voneinander gleichmäßig unter Ausbildung eines Rasters beabstandet. Der Abstand zwischen benachbarten Flachleitern sollte, bezogen jeweils auf die Längsachse der Flachleiter, zwischen 0,3 mm und 5 mm, bevorzugt 0,5 bis 2 mm liegen, wobei ein Abstand von 0,93 mm bevorzugt ist. Der erfindungsgemäße elektrische Verbinder sollte mindestens zwei Flachleiter aufweisen. Der erfindungsgemäße elektrische Verbinder weist vorzugsweise nicht mehr als sechzig Flachleiter auf.

Zur Herstellung der Flachleiter können bekannte Verfahren wie Stanzen, Ätzen, Walzen, Prägen und Fräsen eingesetzt werden. Bevorzugt werden die Leiterbahnen durch Ätzen oder Stanzen, ausgehend von einem Blechstreifen gebildet. Dabei ist Ätzen besonders bevorzugt. Die ersten Abschnitte können beispielsweise durch den Einsatz von Walzen, in deren Mantelflächen Kerben ausgebildet sind, hergestellt werden.

Die Isolationszone umfasst vorzugsweise eine erste Folie und einer zweite Folie, zwischen denen die Flachleiter angeordnet sind. Dabei sollten sich die beiden Folien gegenüberliegen. Zur Fixierung der Folien aneinander und an den Flächenseiten der Flachleiter kann Klebstoff vorgesehen sein. Insbesondere können Klebstoffschichten auf die Innenseiten der Folien aufgebracht sein. Die Folien sind vorzugsweise Kunststofffolien. Die Kunststofffolien können beispielsweise aus Polyethylen, Polytetrafluorethylen, Polyamid, Polyurethan oder einem anderen elektrisch isolierenden Kunststoff bestehen.

Die Isolationszone hat vorzugsweise einen im Wesentlichen rechteckigen Querschnitt. Die Längs- und/oder Querkanten der Isolationszone können abgerundet sein. Die Flachseiten der Isolationszone müssen nicht vollkommen eben, sondern komplementär zu den Konturen der Leiter, soweit diese innerhalb der Isolationszone verlaufen, geformt sein. Unter dem Begriff "Querkante" der Isolationszone wird hier eine Kante der Isolationszone verstanden, die quer zur Längsrichtung der Flachleiter verläuft.

Der erfindungsgemäße elektrische Verbinder bietet den Vorteil, dass er wie ein starres Bauelement gehandhabt werden kann, sein Verhalten aufgrund der vereinfachten Biegemöglichkeit aber dem eines flexiblen Bauelementes ähnelt. Der erfindungsgemäße elektrische Verbinder ist zur automatischen Montage, beispielsweise mittels des Reflow-Lötens, geeignet.

Ferner ist die Verwendung eines erfindungsgemäßen elektrischen Verbinders zum elektrischen Verbinden von Leiterplatten vorgesehen. Die Anschlüsse der beiden Leiterplatten müssen nicht in einer Ebene liegen. Der erfindungsgemäße elektrische Verbinder kann ferner zur Verbinden elektrischer und elektronischer Bauelemente eingesetzt werden, insbesondere solcher Bauelemente, die Leiterplatten besitzen.

Die Erfindung wird nachstehend anhand von Ausführungsbeispielen unter Bezugnahme auf die Zeichnungen näher erläutert. Dabei zeigen
- Fig. 1: Ansichten eines erfindungsgemäßen elektrischen Verbinders (Fig. 1a: Draufsicht; Fig. 1b: Ansicht von vorn; Fig. 1c: Seitenansicht);
- Fig. 2: eine perspektivische Darstellung eines bearbeiteten Blechstreifens zur Herstellung einer ersten Ausführungsform eines erfindungsgemäßen elektrischen Verbinders;
- Fig. 3: eine Teil-Seitenansicht eines Flachleiters aus dem in Fig. 2 gezeigten Blechstreifen;
- Fig. 4: eine perspektivische Darstellung eines bearbeiteten Blechstreifens zur Herstellung einer zweiten Ausführungsform eines erfindungsgemäßen elektrischen Verbinders;
- Fig. 5: eine Teil-Seitenansicht eines Flachleiters aus dem in Fig. 4 gezeigten Blechstreifen;
- Fig. 6: eine perspektivische Darstellung eines bearbeiteten Blechstreifens zur Herstellung einer dritten Ausführungsform eines elektrischen Verbinders (nicht erfindungsgemäß);
- Fig. 7: eine Teil-Seitenansicht eines Flachleiters aus dem in Fig. 6 gezeigten Blechstreifen (nicht erfindungsgemäß); und
- Fig. 8: Ansichten eines elektrischen Verbinders mit Flachleitern der Figuren 6 und 7 (Fig. 8a: Seitenansicht; Fig. 8b: Detail D von Fig. 8a) (nicht erfindungsgemäß);
- Fig. 9: Ansichten des in Fig. 8 gezeigten elektrischen Verbinders, der zwei Leiterplatten verbindet (Fig. 9a: Seitenansicht; Fig. 9b Draufsicht) (nicht erfindungsgemäß);
- Fig. 10: weitere Ansichten des in Fig. 8 gezeigten elektrischen Verbinders, der zwei Leiterplatten verbindet (Fig. 10a: Seitenansicht; Fig. 10b perspektivische Darstellung) (nicht erfindungsgemäß);
- Fig. 11: weitere Ansichten des in Fig. 8 gezeigten elektrischen Verbinders, der zwei Leiterplatten verbindet (Fig. 11a: Seitenansicht; Fig. 11b perspektivische Darstellung) (nicht erfindungsgemäß);
- Fig. 12: weitere Ansichten des in Fig. 8 gezeigten elektrischen Verbinders, der zwei Leiterplatten verbindet (Fig. 12a: Seitenansicht; Fig. 12b perspektivische Darstellung) (nicht erfindungsgemäß) und
- Fig. 13: weitere Ansichten des in Fig. 8 gezeigten elektrischen Verbinders, der zwei Leiterplatten verbindet (Fig. 13a: Seitenansicht; Fig. 13b perspektivische Darstellung) (nicht erfindungsgemäß).

In den folgenden Zeichnungen haben gleiche Bezugszeichen die gleiche Bedeutung, sofern nicht ausdrücklich etwas anderes angegeben ist.

Die in den Figuren 1a-c gezeigte erste Ausführungsform eines erfindungsgemäßen elektrischen Verbinders 1 weist mehrere parallele, voneinander beabstandete Flachleiter 2 auf. Die Flachleiter 2 sind in ein elektrisch isolierendes Material eingebettet, wodurch eine Isolationszone 3 erhalten wird. Die Isolationszone 3 wird erhalten, indem die Flachleiter 2 zwischen zwei Kunststofffolien 10 sandwichartig eingelegt werden. Die Flachleiter 2 treten an den Querkanten 4 der Isolationszone 3 aus dieser aus. Außerhalb der Isolationszone 3 weisen die Leiter 2 freiliegende Abschnitte 5 auf. Es ist in Fig. 1c zu erkennen, dass die freiliegenden Abschnitte 5 der Flachleiter 2 z-förmig abgewinkelt sind. Abgesehen von den Konturen der Flachleiter 2 ist die Isolationszone 3 flach.

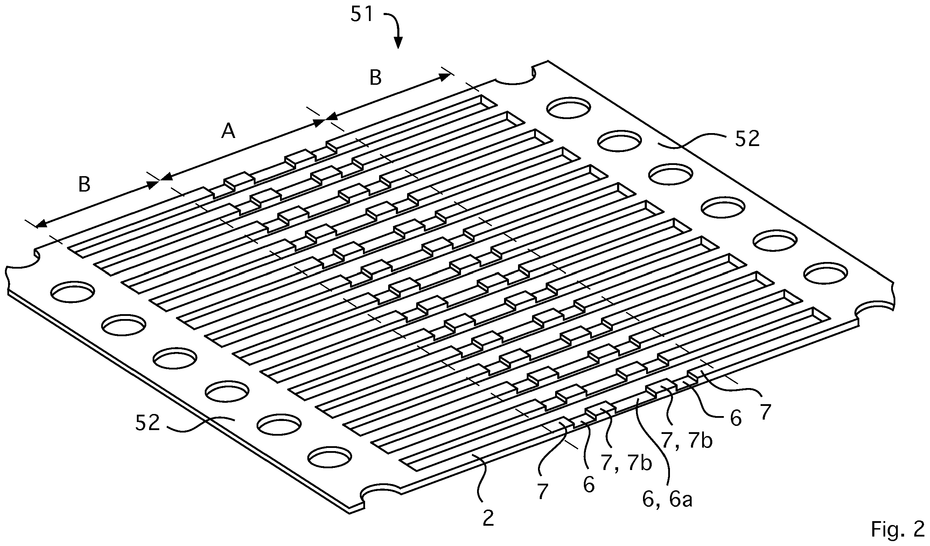

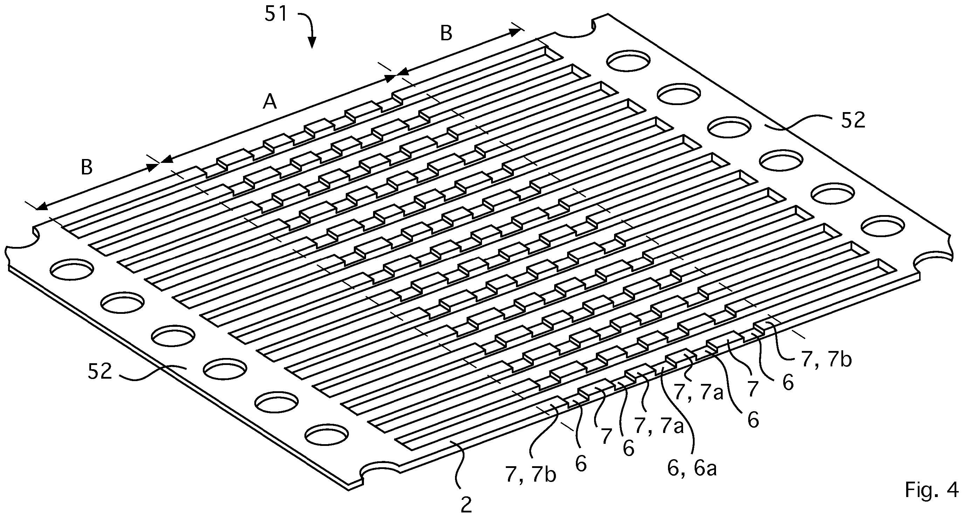

Die Flachleiter 2 weisen innerhalb der Isolationszone 3 jeweils zumindest einen ersten Abschnitt 6 auf, der zwischen zwei zweiten Abschnitten 7 liegt (siehe Figuren 2 bis 7). Die ersten Abschnitte 6 der Flachleiter weisen eine Dicke auf, die 50 % der Dicke der zweiten Abschnitte 7 beträgt.

Die Figuren 2 bis 7 zeigen Blechstreifen 51, die zur Herstellung von Ausführungsformen des elektrischen Verbinders eingesetzt werden können. Aus den Blechstreifen 51 sind die Flachleiter 2 herausgearbeitet, beispielsweise durch Stanzen oder Ätzen. Im Fall des Stanzens werden derartige Blechstreifen 51 auch als Stanzgitter bezeichnet. Die Flachleiter 2 sind in dem Blechstreifen 51 durch Stege 52 miteinander verbunden. Aus den Blechstreifen 51 werden die Flachleiter 2 erhalten, indem die Stege 52 abgetrennt werden.

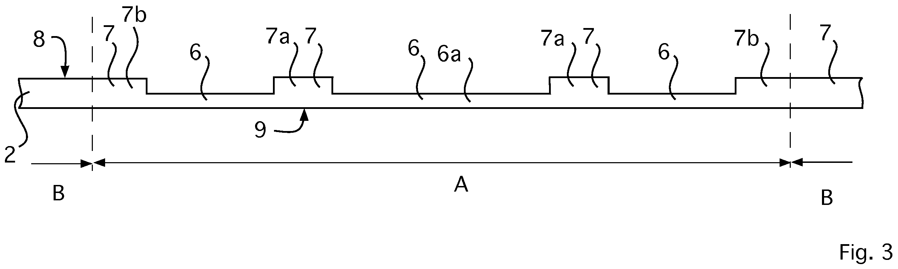

Die Flachleiter 2 der Blechstreifen 51 weisen jeweils einen ersten Bereich A auf, der zwischen zwei zweiten Bereichen B, die die gleiche Länge aufweisen, liegt (siehe Figuren 2, 4 und 6). Der erste Bereich A und angrenzende Abschnitte der zweiten Bereiche eines Flachleiters 2 sind in den Figuren 3, 5 und 7 gezeigt. Der in Fig. 3 gezeigte erste Bereich A weist drei erste Abschnitte 6 auf. Der mittlere erste Abschnitt 6a der drei ersten Abschnitte 6, also der erste Abschnitt 6a, der zwischen den beiden anderen ersten Abschnitten 6 liegt, ist mittig, bezogen auf die Länge des Flachleiters 2, angeordnet. Der mittige erste Abschnitt 6a weist eine Länge auf, die dem 1,5-fachen der Länge der beiden anderen Abschnitte 6 entspricht, die beide die gleiche Länge aufweisen. Die drei ersten Abschnitte 6 weisen eine Dicke auf, die 50 % der Dicke der zweiten Abschnitte 7 entspricht. Die Dicke der zweiten Abschnitte 7 entspricht der Dicke des Flachleiters 2 in den zweiten Bereichen B. Ein Versatz zwischen den ersten Abschnitten 6 und zweiten Abschnitten 7 ist nur an einer Flächenseite 8 des Flachleiters 2 ausgebildet. Auf der anderen Flächenseite 9 des Flachleiters 2 besteht kein Versatz zwischen den ersten Abschnitten 6 und zweiten Abschnitten 7. Die beiden zweiten Abschnitte 7a, die an den mittigen ersten Abschnitt 6a angrenzen, haben die gleiche Länge, die der Hälfte der Länge des mittigen ersten Abschnittes 6a entspricht. Die beiden zweiten Abschnitte 7b, die den Übergang zwischen dem ersten Bereich A und den angrenzenden zweiten Bereichen B bilden, haben beide die gleiche Länge, sind aber wesentlich länger als die zweiten Abschnitte 7a.

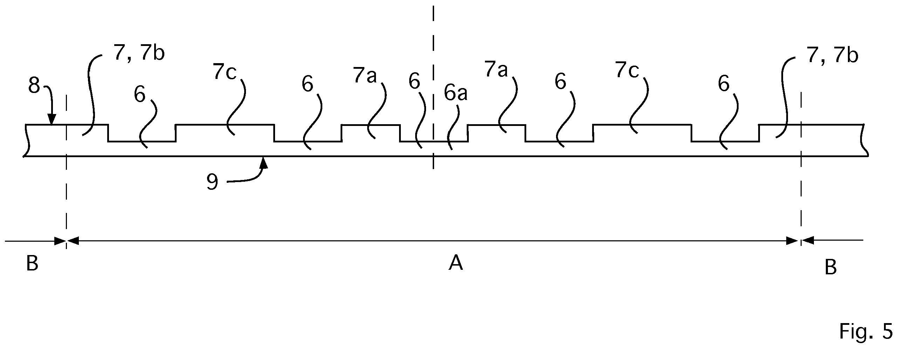

Der in Fig. 5 gezeigte erste Bereich A weist fünf erste Abschnitte 6 auf. Der mittlere erste Abschnitt 6a der fünf ersten Abschnitte 6 ist mittig, bezogen auf die Länge des Flachleiters 2, angeordnet. Die ersten Abschnitte 6 weisen alle die gleiche Länge auf. Die fünf ersten Abschnitte 6 weisen eine Dicke auf, die 50 % der Dicke der zweiten Abschnitte 7 entspricht. Die Dicke der zweiten Abschnitte 7 entspricht der Dicke des Flachleiters 2 in den zweiten Bereichen B. Ein Versatz zwischen den ersten Abschnitten 6 und zweiten Abschnitten 7 ist nur an einer Flächenseite 8 des Flachleiters 2 ausgebildet. Auf der anderen Flächenseite 9 des Flachleiters 2 besteht kein Versatz zwischen den ersten Abschnitten 6 und zweiten Abschnitten 7. Die beiden zweiten Abschnitte 7a, die an den mittigen ersten Abschnitt 6a angrenzen, haben die gleiche Länge. Sie entspricht 80 % der Länge der ersten Abschnitte 6. Die beiden zweiten Abschnitte 7b, die den Übergang zwischen dem ersten Bereich A und den angrenzenden zweiten Bereichen B bilden, haben beide die gleiche Länge, sind aber wesentlich länger als die zweiten Abschnitte 7a und 7c, die zwischen den äußeren ersten Abschnitten 6 liegen. Die zweiten Abschnitte 7c haben jeweils die gleiche Länge. Sie entspricht 120 % der Länge der ersten Abschnitte 6.

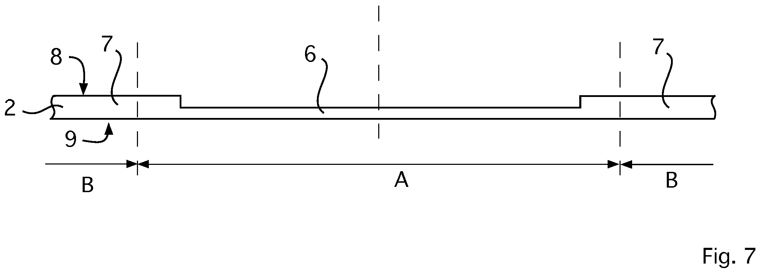

Der in Fig. 7 (nicht erfindungsgemäß) gezeigte erste Bereich A weist genau einen ersten Abschnitt 6 auf. Dieser erste Abschnitt 6 ist mittig, bezogen auf die Länge des Flachleiters 2, angeordnet. Der erste Abschnitt 6 weist eine Dicke auf, die 50 % der Dicke der zweiten Abschnitte 7 entspricht. Die Dicke der zweiten Abschnitte 7 entspricht der Dicke des Flachleiters 2 in den zweiten Bereichen B. Ein Versatz zwischen dem ersten Abschnitt 6 und den zweiten Abschnitten 7 ist nur an einer Flächenseite 8 des Flachleiters 2 ausgebildet. Auf der anderen Flächenseite 9 des Flachleiters 2 besteht kein Versatz zwischen dem ersten Abschnitt 6 und den zweiten Abschnitten 7. Die beiden zweiten Abschnitte 7, die an den ersten Abschnitt 6 angrenzen, haben die gleiche Länge.

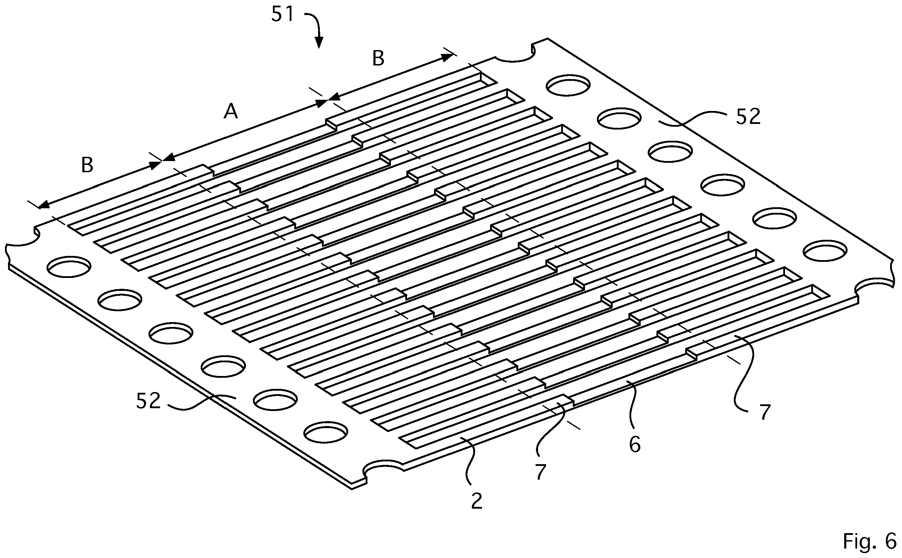

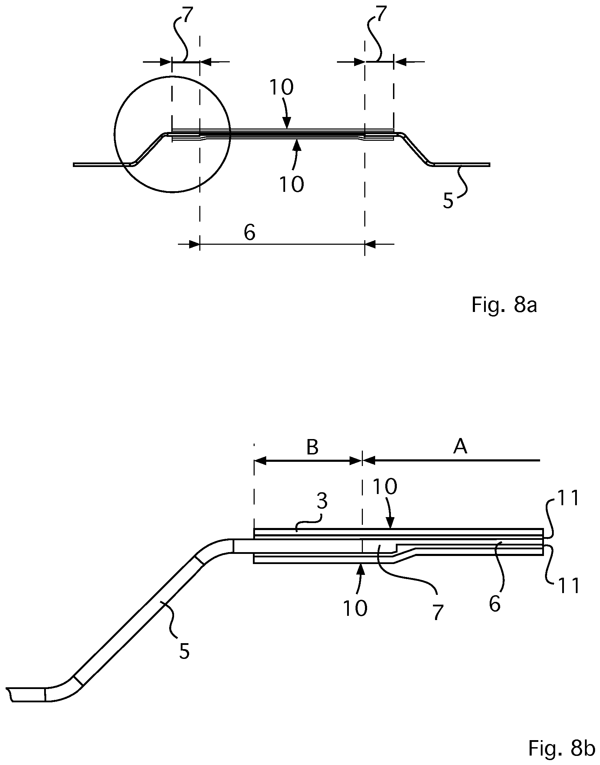

In den Figuren 8a und 8b ist eine Ausführungsform eines elektrischen Verbinders 1 (nicht erfindungsgemäß) gezeigt, die der in den Figuren 1a-c gezeigten ersten Ausführungsform entspricht, außer dass in der Isolationszone 3 die Flachleiter 2 aus dem in Fig. 6 gezeigten Bleichstreifen 51 (nicht erfindungsgemäß) stammen. Die Flachleiter 2 der Ausführungsform weisen somit nur einen ersten Abschnitt 6 auf, der zwischen zwei zweiten Abschnitten 7 liegt. Es ist in Fig. 8b zu erkennen, dass eine der Kunststofffolien 10 den Versatz, der an der Flächenseite 8 zwischen dem ersten Abschnitt 6 und den zweiten Abschnitten 7 ausgebildet ist, überdeckt. Die Kunststofffolien 10 sind auf den einander zugewandten Flächenseiten jeweils mit einer Klebstoffschicht 11 beschichtet.

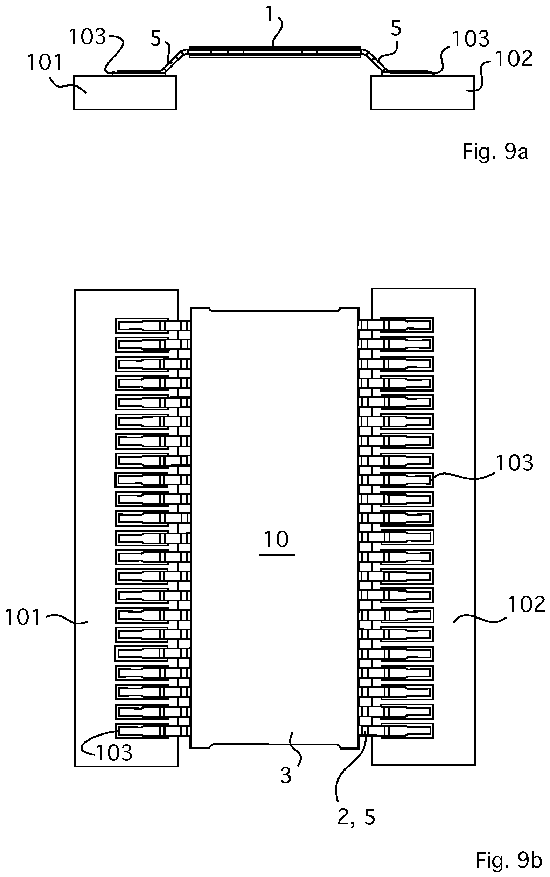

Die Figuren 9 bis 13 (nicht erfindungsgemäß) zeigen den in Fig. 8 dargestellten elektrischen Verbinder 1 im montierten Zustand, in dem er zwei Leiterplatten 101, 102 elektrisch miteinander verbindet. Dabei sind die freiliegenden Abschnitte 5 der Flachleiter 2 mit Kontaktflächen 103, die an den Leiterplatten 101, 102 ausgebildet sind, verlötet. Die Flächenseite 8 der Flachleiter 2, in der ein Versatz zwischen den ersten und zweiten Abschnitten 6, 7 ausgebildet ist, befinden sich auf der Seite des elektrischen Verbinders, die den Leiterplatten 101, 102 zugewandt ist. Die Seite einer Leiterplatte 101, 102, auf der die Kontaktflächen 103 ausgebildet sind, wird im Folgenden als Kontaktseite bezeichnet. Die Konturen der Flachleiter 2 innerhalb der Isolationszone sind durch gestrichelte Linien angedeutet.

In Fig. 9 (nicht erfindungsgemäß) befinden sich die Kontaktseiten der beiden Leiterplatten 101, 102 in derselben Ebene (bezogen auf die Darstellung ist dies die Oberseite beider Leiterplatten). Die Flachleiter 2 des elektrischen Verbinders 1 sind innerhalb der Isolationszone 3 nicht gekrümmt.

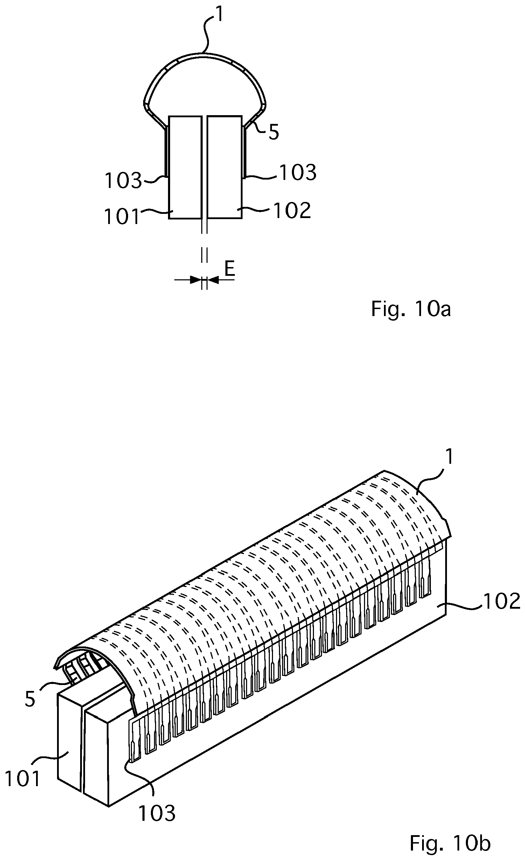

In Fig. 10 (nicht erfindungsgemäß) sind die Kontaktseiten der beiden Leiterplatten 101, 102 einander abgewandt. Der Abstand E zwischen den beiden Leiterplatten 101, 102 ist äußerst gering. Die Flachleiter 2 des elektrischen Verbinders 1 sind innerhalb der Isolationszone 3 stark gekrümmt. Nach der Montage des elektrischen Verbinders 1 auf die Leiterplatten 101, 102 wurden die Flachleiter 2 innerhalb der Isolationszone 3 stark gebogen.

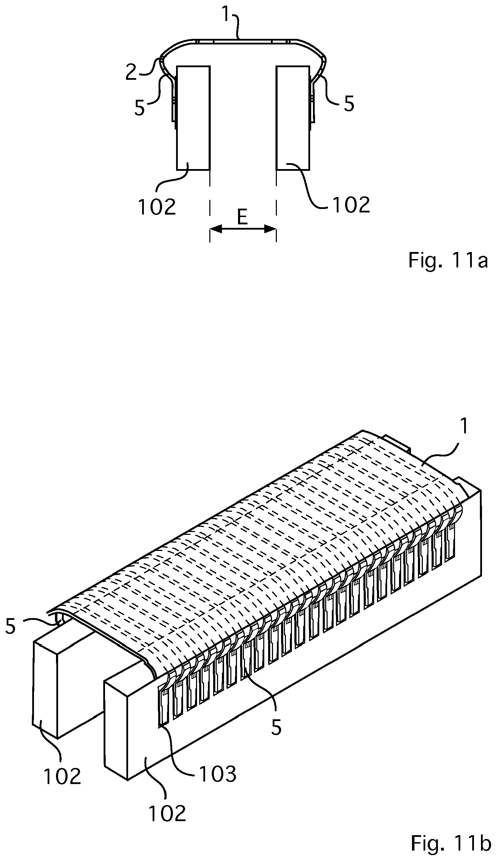

In Fig. 11 (nicht erfindungsgemäß) sind die Kontaktseiten der beiden Leiterplatten 101, 102 einander abgewandt. Der Abstand E zwischen den beiden Leiterplatten 101, 102 ist größer als in Fig. 10. Die Flachleiter 2 des elektrischen Verbinders 1 sind innerhalb der Isolationszone 3 geringer als in Fig. 10 gekrümmt. Nach der Montage des elektrischen Verbinders 1 auf die Leiterplatten 101, 102 wurden die Flachleiter 2 innerhalb der Isolationszone 3 gebogen.

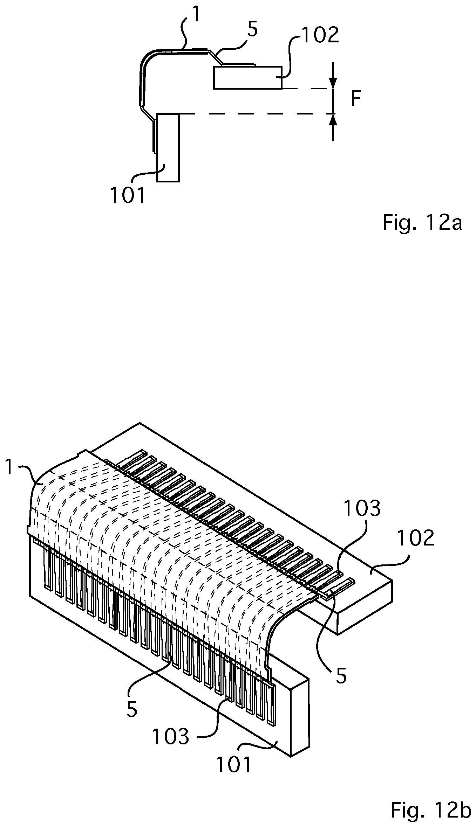

In Fig. 12 (nicht erfindungsgemäß) ist die Kontaktseite der Leiterplatte 101 orthogonal versetzt zur Kontaktseite der Leiterplatte 102, wobei die Kontaktseiten der Leiterplatten 101, 102 jeweils an der Seite der Leiterplatten 101, 102 ausgebildet sind, die der jeweils anderen Leiterplatte abgewandt ist. Der Abstand E zwischen den beiden Leiterplatten 101, 102 ist gering. Die Flachleiter 2 des elektrischen Verbinders 1 sind innerhalb der Isolationszone 3 stark gekrümmt. Nach der Montage des elektrischen Verbinders 1 auf die Leiterplatten 101, 102 wurden die Flachleiter 2 innerhalb der Isolationszone 3 stark gebogen.

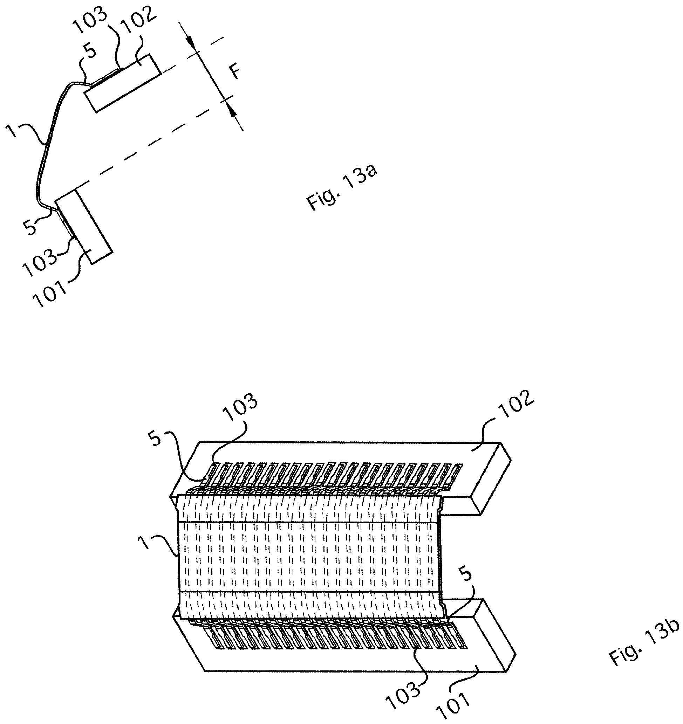

In Fig. 13 (nicht erfindungsgemäß) ist die Kontaktseite der Leiterplatte 101 orthogonal versetzt zur Kontaktseite der Leiterplatte 102, wobei die Kontaktseiten der Leiterplatten 101, 102 jeweils an der Seite der Leiterplatten 101, 102 ausgebildet sind, die der jeweils anderen Leiterplatte abgewandt ist. Der Abstand E zwischen den beiden Leiterplatten 101, 102 ist größer als in Fig. 12. Die Flachleiter 2 des elektrischen Verbinders 1 sind innerhalb der Isolationszone 3 geringer als in Fig. 12 gekrümmt. Nach der Montage des elektrischen Verbinders 1 auf die Leiterplatten 101, 102 wurden die Flachleiter 2 innerhalb der Isolationszone 3 gebogen.

### Bezugszeichenliste

- 1: Elektrischer Verbinder
- 2: Flachleiter
- 3: Isolationszone
- 4: Querkante
- 5: freiliegender Abschnitt
- 6: erster Abschnitt
- 7: zweiter Abschnitt
- 8: Flächenseite
- 9: Flächenseite
- 10: Kunststofffolie
- 11: Klebstoffschicht

- A: erster Bereich
- B: zweiter Bereich
- E: Abstand

- 51: Blechstreifen
- 52: Steg

- 101: Leiterplatte
- 102: Leiterplatte
- 103: Kontaktfläche

## Patentansprüche

1. Elektrischer Verbinder, der insbesondere zum Verbinden von Leiterplatten geeignet ist, wobei der Verbinder (1) mehrere voneinander beabstandete Flachleiter (2) aufweist, die in ein elektrisch isolierendes Material unter Ausbildung einer Isolationszone (3), in der die Flachleiter (2) parallel zueinander verlaufen, eingebettet sind und an ihren Enden jeweils mit einem freiliegenden Abschnitt (5) über die Querkanten (4) der Isolationszone (3) hinausragen, **dadurch gekennzeichnet, dass** jeder Flachleiter (2) innerhalb der Isolationszone (3) mehrere erste Abschnitte (6) aufweist, wobei jeder der ersten Abschnitte (6) zwischen zwei zweiten Abschnitten (7) angeordnet ist, die ersten Abschnitte (6) eine geringere Dicke als die zweiten Abschnitte (7) aufweisen, die Flachleiter (2) innerhalb der Isolationszone (3) die gleiche Breite aufweisen und die ersten und zweiten Abschnitte (6, 7) eines Flachleiters (2) die gleiche Breite aufweisen.

2. Elektrischer Verbinder nach Anspruch 1, **dadurch gekennzeichnet, dass** die ersten und zweiten Abschnitte (6, 7) eine gemeinsame erste Flächenseite (9) aufweisen, während die zweite Flächenseite (8) des ersten Abschnittes (6) versetzt zu der zweiten Flächenseite (8) der zweiten Abschnitte (7) ausgebildet ist.

3. Elektrischer Verbinder nach Anspruch 1, **dadurch gekennzeichnet, dass** die erste Flächenseite (9) des ersten Abschnittes (6) versetzt zu den ersten Flächenseiten (9) der zweiten Abschnitte (7) und die zweite Flächenseite (8) des ersten Abschnittes (6) versetzt zu der zweiten Flächenseite (8) der zweiten Abschnitte (7) angeordnet ist.

4. Elektrischer Verbinder nach einem der vorstehenden Ansprüche, **dadurch gekennzeichnet, dass** der Flachleiter (2) zumindest drei erste Abschnitte (6) aufweist.

5. Elektrischer Verbinder nach einem der vorstehenden Ansprüche, **dadurch gekennzeichnet, dass** der Flachleiter (2) zumindest einen ersten Abschnitt (6) einer ersten Länge und zumindest einen ersten Abschnitt (6) einer zweiten Länge aufweist, wobei die erste Länge länger als die zweite Länge ist.

6. Elektrischer Verbinder nach einem der vorstehenden Ansprüche, **dadurch gekennzeichnet, dass** der Flachleiter (2) zumindest einen zweiten Abschnitt (7) einer ersten Länge und zumindest einen zweiten Abschnitt (7) einer zweiten Länge aufweist, wobei die erste Länge länger als die zweite Länge ist.

7. Elektrischer Verbinder nach einem der vorstehenden Ansprüche, **dadurch gekennzeichnet, dass** an beide Querkanten (4) der Isolationszone (3) zweite Abschnitte (7) des Flachleiters (2) angrenzen.

8. Elektrischer Verbinder nach einem der vorstehenden Ansprüche, **dadurch gekennzeichnet, dass** alle Flachleiter (2) den gleichen Aufbau besitzen und die ersten und zweiten Abschnitte (6, 7) der Flachleiter (2) fluchtend zueinander ausgebildet sind.

9. Elektrischer Verbinder nach einem der vorstehenden Ansprüche, **dadurch gekennzeichnet, dass** jeder Flachleiter (2) innerhalb der Isolationszone (3) einen ersten Bereich (A) aufweist, der zwischen zwei zweiten Bereichen (B) liegt, wobei im ersten Bereich (A) erste und zweite Abschnitte (6, 7) ausgebildet sind, die ersten Abschnitte (6) nur im ersten Bereich (A) ausgebildet sind, die zweiten Bereiche (B) an Querkanten (4) der Isolationszone (3) angrenzen und die Dicke der Flachleiter (2) in den zweiten Bereichen (B) der Dicke der zweiten Abschnitte (7) der Flachleiter (2) im ersten Bereich (A) entspricht.

10. Elektrischer Verbinder nach Anspruch 9, **dadurch gekennzeichnet, dass** der erste Bereich (A) und die zweiten Bereiche (B) jeweils die gleiche Länge aufweisen.

11. Elektrischer Verbinder nach einem der vorstehenden Ansprüche, **dadurch gekennzeichnet, dass** die Dicke eines ersten Abschnittes (6) 95 % oder weniger der Dicke eines zweiten Abschnittes (7) beträgt.

12. Elektrischer Verbinder nach einem der vorstehenden Ansprüche, **dadurch gekennzeichnet, dass** die Dicke eines ersten Abschnittes (6) 25 % oder mehr der Dicke eines zweiten Abschnittes (7) beträgt.

13. Elektrischer Verbinder nach einem der vorstehenden Ansprüche, **dadurch gekennzeichnet, dass** die Isolationszone (3) eine erste Folie (10) und eine zweite Folie (10) umfasst, zwischen denen die Flachleiter (2) angeordnet sind, wobei zur Fixierung der Folien (10) Klebstoff (11) vorgesehen ist.

## Claims

1. An electric connector that is particularly suitable for connecting printed circuit boards, wherein the connector (1) has several flat conductors (2) that are spaced apart from each other and that are embedded in an electrically insulating material to form an insulation zone (3) in which the flat conductors (2) extend parallel to each other and at their ends each with an exposed portion (5) project over the transverse edges (4) of the insulation zone (3), **characterized in that** each of the flat conductors (2), within the insulation zone (3), has a plurality of first portions (6), wherein each of the first portions (6) is arranged between two second portions (7), the first portions (6) have a smaller thickness than the second portions (7), the flat conductors (2), within the insulation zone (3), have the same width, and the first and second portions (6, 7) of a flat conductor (2) have the same width.

2. The electric connector according to claim 1, **characterized in that** the first and second portions (6, 7) have a common first surface side (9), whereas the second surface side (8) of the first portion (6) is formed offset to the second surface side (8) of the second portions (7).

3. The electric connector according to claim 1, **characterized in that** the first surface side (9) of the first portion (6) is arranged offset to the first surface sides (9) of the second portions (7) and the second surface side (8) of the first portion (6) is arranged offset to the second surface side (8) of the second portions (7).

4. The electric connector according to any one of the preceding claims, **characterized in that** the flat conductor (2) has at least three first portions (6).

5. The electric connector according to any one of the preceding claims, **characterized in that** the flat conductor (2) has at least one first portion (6) of a first length and at least one first portion (6) of a second length with the first length being longer than the second length.

6. The electric connector according to any one of the preceding claims, **characterized in that** the flat conductor (2) has at least one second portion (7) of a first length and at least one second portion (7) of a second length with the first length being longer than the second length.

7. The electric connector according to any one of the preceding claims, **characterized in that** second portions (7) of the flat conductor (2) abut on both transverse edges (4) of the insulation zone (3).

8. The electric connector according to any one of the preceding claims, **characterized in that** all of the flat conductors (2) have the same structure and the first and second portions (6, 7) of the flat conductors (2) are formed in alignment to each other.

9. The electric connector according to any one of the preceding claims, **characterized in that** each of the flat conductors (2), within the insulation zone (3), has a first region (A) lying between two second regions (B), wherein first and second portions (6, 7) are formed in the first region (A), the first portions (6) are only formed in the first region (A), the second regions (B) abut on the transverse edges (4) of the insulation zone (3), and the thickness of the flat conductors (2) in the second regions (B) corresponds to the thickness of the second portions (7) of the flat conductors (2) in the first region (A).

10. The electric connector according to claim 9, **characterized in that** the first region (A) and the second regions (B) each are of the same length.

11. The electric connector according to any one of the preceding claims, **characterized in that** the thickness of a first portion (6) is 95% or less of the thickness of a second portion (7).

12. The electric connector according to any one of the preceding claims, **characterized in that** the thickness of a first portion (6) is 25% or more of the thickness of a second portion (7).

13. The electric connector according to any one of the preceding claims, **characterized in that** the insulation zone (3) comprises a first film (10) and a second film (10) between which the flat conductors (2) are arranged, wherein an adhesive agent (11) is provided for fixing the films (10).

## Revendications

1. Elément de connexion électrique, qui est apte en particulier à connecter des circuits imprimés, l'élément de connexion (1) présentant plusieurs conducteurs plats (2) espacés entre eux, qui sont noyés dans un matériau électriquement isolant en formant une zone isolante (3) dans laquelle les conducteurs plats (2) s'étendent parallèlement et qui font saillie à leurs extrémités avec une partie (5) dénudée par l'arête transversale (4) de la zone isolante (3), **caractérisé par le fait que** chaque conducteur plat (2) présente à l'intérieur de la zone isolante (3) plusieurs premières parties (6), chacune des premières parties (6) étant disposée entre deux deuxièmes parties (7), les premières parties (6) présentant une moindre épaisseur que les deuxièmes parties (7), les conducteurs plats (2) présentant la même largeur à l'intérieur de la zone isolante (3) et les premières et deuxièmes parties (6, 7) d'un conducteur (2) présentant la même largeur.

2. Elément de connexion électrique selon la revendication 1, **caractérisé par le fait que** les premières et deuxièmes parties (6, 7) présentent une première face plate (9) commune, tandis que la deuxième face plate (8) de la première partie (6) est configurée en décalage par rapport à la deuxième face plate (8) des deuxième parties (7).

3. Elément de connexion électrique selon la revendication 1, **caractérisé par le fait que** la première face plate (9) de la première partie (6) est disposée en décalage par rapport aux premières faces plates (9) des deuxièmes parties (7) et que la deuxième face plate (8) de la première partie (6) est disposée en décalage par rapport à la deuxième face plate (8) des deuxièmes parties (7).

4. Elément de connexion électrique selon une des caractéristiques précédentes, **caractérisé par le fait que** le conducteur plat (2) présente au moins trois premières parties (6).

5. Elément de connexion électrique selon une des caractéristiques précédentes, **caractérisé par le fait que** le conducteur plat (2) présente au moins une première partie (6) d'une première longueur et au moins une première partie (6) d'une deuxième longueur, la première longueur étant plus longue que la deuxième longueur.

6. Elément de connexion électrique selon une des caractéristiques précédentes, **caractérisé par le fait que** le conducteur plat (2) présente au moins une deuxième partie (7) d'une première longueur et au moins une deuxième partie (7) d'une deuxième longueur, la première longueur étant plus longue que la deuxième longueur.

7. Elément de connexion électrique selon une des caractéristiques précédentes, **caractérisé par le fait que** des deuxièmes parties (7) du conducteur plat (2) sont contiguës aux deux arêtes transversales (4) de la zone isolante (3).

8. Elément de connexion électrique selon une des caractéristiques précédentes, **caractérisé par le fait que** tous les conducteurs plats (2) possèdent la même configuration et que les premières et deuxièmes parties (6, 7) des conducteurs plats (2) sont alignées entre elles.

9. Elément de connexion électrique selon une des caractéristiques précédentes, **caractérisé par le fait que** chaque conducteur plat (2) présente, à l'intérieur de la zone isolante (3), un premier domaine (A) qui est situé entre deux deuxièmes domaines (B), étant donné que des premières et des deuxièmes parties (6, 7) sont formées dans le premier domaine (A), que les premières parties (6) sont formées seulement dans le premier domaine (A), que les deuxièmes domaines (B) sont contigus aux arêtes transversales (4) de la zone isolante (3) et que l'épaisseur des conducteurs (2) dans les deuxièmes domaines (B) correspond à l'épaisseur des deuxièmes parties (7) des conducteurs plats (2) dans le premier domaine (A).

10. Elément de connexion électrique selon la revendication 9, **caractérisé par le fait que** le premier domaine (A) et les deuxièmes domaines (B) présentent chacun la même longueur.

11. Elément de connexion électrique selon une des caractéristiques précédentes, **caractérisé par le fait que** l'épaisseur d'une première partie (6) comprend 95 % ou moins de l'épaisseur d'une deuxième partie (7).

12. Elément de connexion électrique selon une des caractéristiques précédentes, **caractérisé par le fait que** l'épaisseur d'une première partie (6) comprend 25 % ou plus de l'épaisseur d'une deuxième partie (7).

13. Elément de connexion électrique selon une des caractéristiques précédentes, **caractérisé par le fait que** la zone isolante (3) comprend une première feuille (10) et une deuxième feuille (10) entre lesquelles sont disposés les conducteurs plats (2), la fixation des feuilles (10) étant prévue avec de la colle (11).
